# FASCICULE DE BREVET EUROPEEN

(11) **EP 2 769 404 B1**
(45) Date de publication et mention de la délivrance du brevet: **24.05.2023**
(21) Numéro de dépôt: 12784302.7
(22) Date de dépôt: 19.10.2012
(51) Int. Cl.: H01L 21/208, H01L 21/368, B82Y 10/00, B82Y 40/00, C01B 19/00

(54) **PROCEDE DE CROISSANCE EN EPAISSEUR COUCHE PAR COUCHE DE NANOFEUILLETS COLLOIDAUX ET MATERIAUX COMPOSES DESDITS NANOFEUILLETS**
VERFAHREN ZUM SCHICHTWEISEN DICKENWACHSTUM VON KOLLOIDALEN NANOSHEETS UND MATERIALIEN AUS DIESEN NANOSHEETS
PROCESS FOR LAYER BY LAYER THICKNESS GROWTH OF COLLOIDAL NANOSHEETS AND MATERIALS COMPOSED OF SAID NANOSHEETS

(30) Priorité: 19.10.2011 FR 1103185
(43) Date de publication de la demande: 27.08.2014
(73) Titulaire: Nexdot, 93230 Romainville (FR)
(72) Inventeur: MAHLER, Benoît, 75013 Paris (FR)
(74) Mandataire: Icosa
(86) Numéro de dépôt international: PCT/FR2012/052395
(87) Numéro de publication internationale: WO 2013/057448

(56) Documents cités:
- US-A1- 2004 110 002
- US-A1- 2009 315 016
- FENGSHI CAI ET AL: "TiO coated SnO nanosheet films for dye-sensitized solar cells", THIN SOLID FILMS, ELSEVIER-SEQUOIA S.A. LAUSANNE, CH, vol. 519, no. 16, 3 mars 2011 (2011-03-03) , pages 5645-5648, XP028089139, ISSN: 0040-6090, DOI: 10.1016/J.TSF.2011.03.013 [extrait le 2011-03-16]
- LI Z ET AL: "Size/shape-controlled synthesis of colloidal CdSe quantum disks: Ligand and temperature effects", 4 mai 2011 (2011-05-04), JOURNAL OF THE AMERICAN CHEMICAL SOCIETY 20110504 AMERICAN CHEMICAL SOCIETY USA, VOL. 133, NR. 17, PAGE(S) 6578 - 6586, XP002678847, *Sections "Introduction"; "Results"; "Discussion"; "Experimental Section"; figures 1-9*
- YI ZHANG ET AL: "Aqueous Layer-by-Layer Epitaxy of Type-II CdTe/CdSe Quantum Dots with Near-Infrared Fluorescence for Bioimaging Applications", SMALL, vol. 5, no. 2, 19 janvier 2009 (2009-01-19), pages 185-189, XP55050695, ISSN: 1613-6810, DOI: 10.1002/smll.200800473
- LI J ET AL: "Preparation, conversion, and comparison of the photocatalytic property of Cd(OH)2, CdO, CdS and CdSe", JOURNAL OF PHYSICS AND CHEMISTRY OF SOLIDS, PERGAMON PRESS, LONDON, GB, vol. 70, no. 9, 1 septembre 2009 (2009-09-01), pages 1285-1289, XP026521656, ISSN: 0022-3697, DOI: 10.1016/J.JPCS.2009.07.014 [extrait le 2009-07-17]
- YU DONG ET AL: "Electronic transport of n-type CdSe quantum dot films: Effect of film treatment", JOURNAL OF APPLIED PHYSICS, AMERICAN INSTITUTE OF PHYSICS. NEW YORK, US, vol. 99, no. 10, 31 mai 2006 (2006-05-31), pages 104315-104315, XP012083284, ISSN: 0021-8979
- ITHURRIA S. ET AL: "Quasi 2D Colloidal CdSe Platelets with Thicknesses Controlled at the Atomic Level", JOURNAL OF THE AMERICAN CHEMICAL SOCIETY, AMERICAN CHEMICAL SOCIETY, vol. 130, no. 49, 14 November 2008 (2008-11-14), pages 16504-16505, XP002573191, ISSN: 0002-7863, DOI: 10.1021/JA807724E [retrieved on 2008-11-14]
- MANNA L ET AL: "Epitaxial Growth and Photochemical Annealing of Graded CdS/ZnS Shells on Colloidal CdSe Nanorods", JOURNAL OF THE AMERICAN CHEMICAL SOCIETY, AMERICAN CHEMICAL SOCIETY, vol. 124, no. 24, 24 May 2002 (2002-05-24) , pages 7136-7145, XP002612686, ISSN: 0002-7863, DOI: 10.1021/JA025946I [retrieved on 2002-05-24]
- KIM S. ET AL: "Type-II Quantum Dots: CdTe/CdSe(Core/Shell) and CdSe/ZnTe(Core/Shell) Heterostructures", JOURNAL OF THE AMERICAN CHEMICAL SOCIETY, vol. 125, no. 38, 29 August 2003 (2003-08-29), pages 11466-11467, XP055276844, ISSN: 0002-7863, DOI: 10.1021/ja0361749
- NASILOWSKI M. ET AL: "Two-Dimensional Colloidal Nanocrystals", CHEMICAL REVIEWS, vol. 116, no. 18, 19 July 2016 (2016-07-19), pages 10934-10982, XP055639610, US ISSN: 0009-2665, DOI: 10.1021/acs.chemrev.6b00164
- LI J J ET AL: "LARGE-SCALE SYNTHESIS OF NEARLY MONODISPERSE CdSe/CdS CORE/SHELL NANOCRYSTALS USING AIR-STABLE REAGENTS VIA SUCCESSIVE ION LAYER ADSORPTION AND REACTION", JOURNAL OF THE AMERICAN CHEMICAL SOCIETY, AMERICAN CHEMICAL SOCIETY, vol. 125, no. 41, 23 September 2003 (2003-09-23), pages 12567-12575, XP008068695, ISSN: 0002-7863, DOI: 10.1021/JA0363563

## Description

### DOMAINE DE L'INVENTION

La présente invention concerne un procédé de croissance en épaisseur d'au moins une face d'un nanofeuillet colloïdal inorganique. L'invention concerne en outre les matériaux homo-structurés ou hétéro-structurés résultant d'un tel procédé ainsi que les applications desdits matériaux. On désigne par nanofeuillet une structure présentant au moins une dimension, l'épaisseur, de taille nanométrique et des dimensions latérales grandes devant l'épaisseur, typiquement plus de 5 fois l'épaisseur. On désigne par homo-structuré un matériau de composition homogène en épaisseur et par hétéro-structuré un matériau de composition hétérogène en épaisseur.

La présente invention concerne plus particulièrement un procédé permettant le dépôt d'au moins une monocouche d'atomes sur au moins un nanofeuillet colloïdal inorganique, cette monocouche étant constituée d'atomes différents de ceux contenus dans le dit nanofeuillet.

### ÉTAT DE LA TECHNIQUE

La fabrication de structures présentant au moins une dimension de taille nanométrique induit l'apparition de propriétés physiques nouvelles. Ces structures ont des caractéristiques qui peuvent notablement différer de celles du matériau massif de composition chimique identique.

Ces faibles dimensions (à l'échelle nanométrique) conduisent en effet à une modification des propriétés électroniques¹, optiques², magnétiques³ ou plasmoniques⁴.

Ces nouveaux matériaux suscitent ainsi un intérêt qui va croissant dans des domaines aussi variés que l'optique, l'imagerie, l'électronique ou la catalyse.

Les différentes nanostructures existantes peuvent être classées en fonction du nombre de dimensions de taille nanométrique qu'elles présentent. Ainsi, un nanocristal isotrope est une structure nanométrique dans les trois dimensions, tandis qu'un nano-fil est une structure nanométrique dans deux dimensions. Manna et al. décrit des nanobâtonnets CdSe ayant une coque CdS/ZnS (Manna et al., Journal of the American Chemical Society, 2002, Vol. 124, p. 7136-7145). Zhang et al. décrit des quantum dots de structure coeur/écorce CdTe/CdSe ("Aqueous layer-by-layer Epitaxy of Type-II CdTe/CdSe Quantum dots with near-infrared fluorescence for bioimaging applications", Small, January 2009, vol.5, no.2, pages 185-189)

IthurriaS. et al. "Quasi 2D Colloïdal CdSe Platelets with Thicknesses Controlled at the Atomic Level", Journal of the American Chemical Society vol. 130, no. 49, 14.11.2008, pages 16504-16505 décrit des nanofeuillets de CdSe.

La présente invention concerne des structures nanométriques dans une seule dimension, à savoir des nanofeuillets, que nous désignerons par la suite indifféremment feuillets ou nanofeuillets. Elle concerne plus particulièrement les nanofeuillets colloïdaux, c'est à dire les nanofeuillets qui peuvent être dispersés en solution. La présente invention a pour objet la croissance ultérieure de nanofeuillets, i.e. la croissance en épaisseur d'un nanofeuillet initial.

La synthèse de nanofeuillets inorganiques colloïdaux a connu un fort développement depuis le début des années 2000. Il est possible de distinguer plusieurs types de synthèses, chacune associée à un ensemble de matériaux différents. Les principales approches existantes, qui seront détaillées dans la suite, sont l'exfoliation directe d'un matériau lamellaire, la synthèse chimique de mono-feuillets de matériaux lamellaires, la croissance de nanofeuillets par empoisonnement (ce qui bloque la croissance) de certaines faces cristallines par des ligands, et enfin le passage par un composé intermédiaire de structure lamellaire subissant une transformation topotactique.

L'exfoliation directe est utilisée couramment afin de produire des nanofeuillets de graphène, d'hydroxydes ou d'oxydes⁵ (TiO₂ par exemple). Le mode de préparation consiste généralement à diminuer l'énergie d'interaction entre les nanofeuillets afin de les séparer mécaniquement par la suite. Dans le cas de composés ioniques on provoque un gonflement de l'espace inter-feuillets (contenant généralement des ions positifs) en réalisant un échange des cations par un ion fortement encombré tel que l'hydroxyde de tétrabutylammonium⁶. Ce gonflement affaiblit les interactions entre les nanofeuillets qui peuvent alors être séparés mécaniquement par sonication par exemple. Dans le cas du graphite, la diminution de l'énergie d'interaction inter-feuillets peut être réalisée par l'utilisation d'un solvant adéquat tel que le N-methylpyrrolidone⁷.Ce type de procédé conduit toujours à l'obtention de mono-feuillets de quelques Angström d'épaisseur. Il n'y a pas de croissance ultérieure possible. La dimension des nanofeuillets dépend de la dimension de l'objet massif exfolié. Un contrôle de l'épaisseur du nanofeuillet n'est pas envisageable, celle-ci étant fixée par la structure lamellaire du composé de départ et donc par sa nature chimique.

Il existe également de nombreuses synthèses directes de mono-feuillets. Il est par exemple possible de faire croître du graphène directement sur un substrat de cuivre. Il est également possible par des méthodes de synthèse en solution de préparer directement des mono-feuillets de GeS ou GeSe⁸ ou encore des feuillets multiples de Bi₂Te₃⁹. Ces synthèses ne permettent toutefois pas de contrôle de l'épaisseur des nanofeuillets ni de croissance en épaisseur de ceux-ci.

Une approche beaucoup plus versatile, permettant de fabriquer des nanofeuillets dans une grande variété de matériaux différents consiste en l'empoisonnement de certaines facettes cristallines par les ligands de surface adéquats. L'adsorption préférentielle de molécules sur certaines faces cristallines du matériau considéré bloque la croissance dans les directions perpendiculaires à ces facettes et induit alors une croissance cristalline fortement anisotrope^{10, 11}. Il est à noter que la molécule empoisonnante peut être de nature très variée : tensio-actifs¹², polymères¹³, thiols¹⁴, amines^{15, 16, 17}, ions inorganiques¹⁸. Les matériaux ainsi synthétisés peuvent être par exemple :
- des nanofeuillets de métaux (PVP^{13, 19, 20}, CTAB²¹, ions^{18, 22})
- des nanofeuillets d'oxydes de terres rares^{17, 23} (acide oléique et/ou oleylamine)
- des nanofeuillets de sulfures (Cu₂S en présence de thiols¹⁴)

Ce mode de fabrication, bien qu'étant extrêmement général, possède tout de même certaines limitations et notamment ne permet pas la croissance ultérieure en épaisseur d'un nanofeuillet initial.

Une autre approche consiste à synthétiser des nanofeuillets en tirant parti de la formation d'un intermédiaire lui-même lamellaire. Cette approche peut être mise à profit afin de réaliser des nanofeuillets de métaux (Cobalt, Nickel ou Cuivre²⁴) ou d'oxydes (oxyde de magnésium MgO²⁵) en passant par un hydroxyde lamellaire. De même, de nombreux chalcogènes lamellaires sont obtenus par formation préalable d'un complexe Métal-(amine primaire) de structure lamellaire qui réagit ultérieurement avec un précurseur de soufre ou de sélénium. Il est ainsi possible de former des nanofeuillets de CdSe²⁶, de CdMnSe²⁷, de ZnS²⁸⁻³¹, ou encore d'In₂S₃³². Il est à noter qu'un complexe plomb-thio-urée lamellaire permet également la formation de nanofeuillets de PbS³³. Cette autre approche a permis pour la première fois d'obtenir des nanofeuillets de chalcogènes dont l'épaisseur est définie à la monocouche atomique près. Ainsi, depuis 2001 sont apparus des protocoles de synthèse permettant de fabriquer des matériaux semi-conducteurs lamellaires hybrides organique/inorganique³⁴. Le nanofeuillet élémentaire de ces matériaux est constitué d'une monocouche ou d'une bicouche semi-conductrice (ZnS³⁵ par exemple), en structure wurtzite, d'axe de zone [1, 1, 0] dont la surface est stabilisée par une amine primaire. Le protocole de synthèse, très général, permet de l'appliquer a des matériaux variés : CdSe, CdS, ZnS, ZnSe, ZnTe ... Cette approche a été partiellement modifiée en 2006 afin d'obtenir des nanofeuillets individuels de CdSe simplement en modifiant la longueur de la chaine alkyle de l'amine primaire utilisée^{26, 36}. Le contrôle de l'épaisseur de ce type de nanofeuillets reste limité et leur épaisseur ne dépasse pas les 5 monocouches. En conséquence, les propriétés optiques de ces nanofeuillets sont très limitées : fluorescence circonscrite dans la région bleue et ultraviolette du spectre visible, largeur à mi-hauteur du pic de fluorescence supérieure à 12nm. De plus, une croissance en épaisseur ultérieure reste impossible sur ces nanofeuillets.

Plus récemment, en 2008, une nouvelle approche qui permet d'améliorer considérablement le contrôle de l'épaisseur des nanofeuillets semi-conducteurs synthétisés a été développée³⁷⁻³⁹. Dans ce cas, les nanofeuillets sont composés d'un nanofeuillet semi-conducteur (CdSe, CdS ou CdTe) de structure zinc-blende, d'axe de zone [0, 0, 1] présentant une couche cationique stabilisé par des carboxylates de chaque côté du nanofeuillet. Ce type de synthèse permet de contrôler très précisément l'épaisseur du nanofeuillet semi-conducteur, qui peut être comprise entre 4 et 11 monocouches suivant le protocole de synthèse utilisé. De tels nanofeuillets semi-conducteurs colloïdaux présentent des propriétés électroniques et optiques novatrices, du fait en particulier de leur épaisseur parfaitement contrôlée. Ainsi, la fluorescence de ces objets est caractérisée par un spectre d'émission très étroit (moins de 10 nm de largeur à mi-hauteur) et les longueurs d'ondes accessibles en fluorescence couvrent l'ensemble du spectre visible. Cependant, cette nouvelle approche ne permet pas la croissance ultérieure en épaisseur d'un nanofeuillet initial.

Ainsi, les méthodes actuelles permettent de synthétiser des nanofeuillets dont l'épaisseur n'est pas toujours bien contrôlée.

Il existe également à ce jour deux types de procédés de croissance en solution de films de semi-conducteurs sur un matériau initial : les procédés de croissance sur des nanocristaux colloïdaux et les procédés de croissance sur substrat.

Dans le cas des procédés de croissance sur des nanocristaux colloïdaux tels que les « quantum dots » (nanocristaux de semi-conducteurs), les procédés de croissance connus font intervenir un excès de ligands et des températures élevées (plus de 200°C)⁴⁰⁻⁴². Le document US 2004/110002 décrit ainsi le dépôt d'une coque sur des nanoparticules sphériques, à haute température, à savoir 100-200°C, dans un mélange trioctylphosphine/oxyde de trioctylphosphine qui joue le rôle de solvant et de ligand fortement coordinant. Dans de telles conditions, il est très difficile d'assurer la stabilité des nanofeuillets.

En effet, du fait de leur structure 2D, les nanofeuillets se dégradent et se dissolvent lorsque ces procédés de croissance sont utilisés.

Dans le cas des procédés de croissance sur substrat, les procédés connus sont mis en oeuvre en solution aqueuse et à température ambiante. On distingue la CBD : « Chemical Bath Déposition » croissance en bain chimique⁴³ et la SILAR : « Successive Ion Layer Adsorption and Reaction » croissance par adsorption et réaction successive de couches ioniques⁴⁴. Ces procédés, pour pouvoir être appliqués à des nanofeuillets, nécessiteraient un ensemble de conditions difficiles à réunir, par exemple une modification préalable des ligands de surface des nanofeuillets, un contrôle précis du pH ou encore une absence de complexants (complexants qui pourraient entraîner une dissolution des nanofeuillets).La stabilité en solution des nanofeuillets inorganiques semi-conducteurs résulte de la présence de ligands organiques et de leur interaction avec le matériau cristallin. La modification de ces interactions par chauffage ou suppression des ligands provoque l'agrégation ou la destruction des nanofeuillets par dissolution ou changement de forme vers une structure thermodynamique plus stable.

Aussi la croissance dans l'épaisseur de ces objets semblait difficile à réaliser avec les techniques connues décrites ci-dessus.

Aucune des méthodes décrites ci-dessus ne permet d'obtenir une particule inorganique comprenant un nanofeuillet initial. Or, ce matériau final présente de nombreux avantages : il est notamment possible de recouvrir tout ou partie du nanofeuillet initial par une ou plusieurs couches d'un matériau différent du matériau constituant le nanofeuillet initial, ce qui permet d'obtenir un matériau final présentant des propriétés très intéressantes, en terme de stabilité ou de propriétés optiques.

L'objet de la présente invention est donc de fournir un nouveau procédé permettant la croissance ultérieure en épaisseur d'un nanofeuillet initial par le biais de dépôt d'au moins une monocouche de matériau inorganique sur ledit nanofeuillet initial.

La présente invention permet donc d'obtenir des particules inorganiques comprenant un nanofeuillet inorganique recouvert partiellement ou totalement par au moins une monocouche de matériau inorganique.

### RÉSUMÉ

Un objet de la présente invention est une particule colloïdale inorganique selon les revendications 1 à 4.

Un autre objet de l'invention est un procédé de croissance en épaisseur d'un nanofeuillet colloïdal inorganique selon les revendications 5 à 7.

Un autre objet de l'invention est un système luminescent, électroluminescent ou étage d'amplification d'un laser comprenant au moins une particule mentionnée ci-dessus.

Un autre objet de l'invention est Catalyseurs comprenant au moins une particule mentionnée ci-dessus.

Un autre objet de l'invention est Cellules photovoltaïques comprenant au moins une particule mentionnée ci-dessus.

Un autre objet de l'invention est Transistors comprenant au moins une particule mentionnée ci-dessus.

### DESCRIPTION DÉTAILLÉE

Au sens de la présente invention, les termes feuillets et nanofeuillets sont équivalents. Un nanofeuillet présente une structure cristalline quasi-2D dont au moins une des dimensions, de préférence l'épaisseur, est inférieure à 1 µm. Les dimensions latérales, i.e. la largeur et la longueur, du nanofeuillet sont grandes par rapport à l'épaisseur, i.e. au moins 1,5 fois plus grandes. Le nanofeuillet est anisotrope.

L'accroissement de l'épaisseur du nanofeuillet initial permet d'étendre de manière significative les caractéristiques spectrales de ce feuillet telles que les spectres d'émission ou d'absorption. Il apparaît donc souhaitable de développer une méthode de croissance en épaisseur pour atteindre des épaisseurs plus grandes. De plus, il serait souhaitable pour de nombreuses applications de pouvoir déposer sur le nanofeuillet initial un matériau différent de celui le constituant.

Ainsi, les particules finales accrues en épaisseur selon l'invention présentent des propriétés nouvelles ou améliorées en comparaison des nanofeuillets initiaux, telles que un rendement quantique élevé, une stabilité accrue, une meilleure stabilité de surface, une faible largeur à mi-hauteur de fluorescence (moins de 30nm, de préférence moins de 25nm), un temps de vie de fluorescence rapide (moins de 40 ns, de préférence moins de 10ns), une section efficace d'absorption importante (environ ou plus de 10⁻¹³ cm² à 400nm), un réglage possible de la longueur d'onde d'émission, une robustesse dans le temps des propriétés optiques, une grande surface spécifique.

La présente invention a donc pour objet une particule selon la revendication 1.

Au sens de la présente invention, le terme « couche » correspond à un film ou une couche continu ou partiel ayant au moins 1 atome d'épaisseur. Le terme « monocouche » correspond à un film ou une couche continu ou partiel ayant 1 atome d'épaisseur. Les atomes composant la couche ou la monocouche peuvent être identiques ou différents.

Dans un mode de réalisation, au moins une partie de la particule ou de l'objet final a une épaisseur supérieure à l'épaisseur du nanofeuillet initial.

Dans un mode de réalisation, la particule ou l'objet final comprend le nanofeuillet initial recouvert en totalité par au moins une monocouche de matériau.

Dans un mode de réalisation, la particule ou l'objet final comprend le nanofeuillet initial recouvert en totalité par une première monocouche de matériau, ladite première monocouche étant recouverte partiellement ou totalement par au moins une seconde monocouche de matériau.

Dans un mode de réalisation, le nanofeuillet initial présente une épaisseur de 0,3 nm à moins de 500 nm, de 5 nm à moins de 250 nm, de 0,3 nm à moins de 100 nm, de 0,3 nm à moins de 50 nm, de 0,3 nm à moins de 25 nm, de 0,3 nm à moins de 20 nm, de 0,3 nm à moins de 15 nm, de 0,3 nm à moins de 10 nm, de 0,3 nm à moins de 5 nm.

Dans un mode de réalisation, au moins une des dimensions latérales (longueur ou largeur) du nanofeuillet initial représente au moins 3,5 fois l'épaisseur du nanofeuillet initial, au moins 4 fois l'épaisseur du nanofeuillet initial, au moins 4,5 fois l'épaisseur du nanofeuillet initial, au moins 5 fois l'épaisseur du nanofeuillet initial.

Dans un mode de réalisation, les dimensions latérales du nanofeuillet initial sont de au moins 0.45 nm à au moins 2500 nm.

Dans un mode de réalisation, au moins une des dimensions latérales du nanofeuillet initial est de 2 nm à 1m, de 2 nm à 100 mm, de 2 nm à 10 mm, de 2 nm à 1 mm, de 2 nm à 100 µm, de 2 nm à 10 µm, de 2 nm à 1 µm, de 2 nm à 100 nm, de 2 nm à 10 nm.

Dans des exemples, qui constituent des modes de réalisation selon l'invention uniquement dans les limites de la revendication 1, le matériau composant le nanofeuillet initial comprend un matériau MxEy, où
M est Zn, Cd, Hg,
E est S, Se, Te, ou un mélange de ceux-ci,
et x et y sont indépendamment un nombre décimal de 0 à 5, et non simultanément nuls.

Dans un mode de réalisation, le matériau semi-conducteur composant le nanofeuillet initial comprend un composant du groupe II-VI.

Dans un mode de réalisation, le matériau composant le nanofeuillet initial comprend au moins un semi-conducteur choisi parmi CdS, CdSe, CdTe, ZnS, ZnSe, ZnTe, HgS, HgSe, HgTe.

Dans un mode de réalisation, le matériau composant le nanofeuillet initial comprend au moins un semi-conducteur choisi préférentiellement parmi CdS, CdSe, CdTe, ZnS, ZnSe, ZnTe.

Dans un mode de réalisation, la particule ou l'objet final présente une épaisseur de 0,5 nm à 10 mm, de 0,5 nm à 1 mm, de 0,5 nm à 100 µm, de 0,5 nm à 10 µm, de 0.5 nm à 1 µm, de 0.5 nm à 500 nm, de 0,5 nm à 250 nm, de 0,5 nm à 100 nm, de 0,5 nm à 50 nm, de 0,5 nm à 25 nm, de 0,5 nm à 20 nm, de 0,5 nm à 15 nm, de 0,5 nm à 10 nm, de 0,5 nm à 5 nm.

Dans un mode de réalisation, au moins une des dimensions latérales (longueur ou largeur) de la particule ou de l'objet final représente au moins 1,5 fois l'épaisseur de la particule ou de l'objet final, au moins 2 fois l'épaisseur de la particule ou de l'objet final, au moins 2,5 fois l'épaisseur de la particule ou de l'objet final, au moins 3 fois l'épaisseur de la particule ou de l'objet final, au moins 3,5 fois l'épaisseur de la particule ou de l'objet final, au moins 4 fois l'épaisseur de la particule ou de l'objet final, au moins 4,5 fois l'épaisseur de la particule ou de l'objet final, au moins 5 fois l'épaisseur de la particule ou de l'objet final.

Dans un mode de réalisation, les dimensions latérales de la particule ou de l'objet final sont de au moins 0.75 nm à au moins 50 mm.

Dans un mode de réalisation, au moins une des dimensions latérales de la particule ou de l'objet final est de 2 nm à 1m, de 2 nm à 100 mm, de 2 nm à 10 mm, de 2 nm à 1 mm, de 2 nm à 100 µm, de 2 nm à 10 µm, de 2 nm à 1 µm, de 2 nm à 100 nm, de 2 nm à 10 nm.

Dans un mode de réalisation, la particule ou l'objet final est hétéro-structuré, i.e. que le nanofeuillet initial et la au moins une monocouche sont composés d'au moins deux matériaux différents.

Dans un mode de réalisation où plusieurs monocouches recouvrent tout ou partie du nanofeuillet initial, ces monocouches sont composées de différents matériaux.

Dans un mode de réalisation où plusieurs monocouches recouvrent tout ou partie du nanofeuillet initial, ces monocouches sont composées de façon à former un gradient de matériaux.

Dans un mode de réalisation, la particule ou l'objet final peut comprendre le nanofeuillet initial et au moins une monocouche recouvrant tout ou partie du nanofeuillet initial, ladite monocouche étant composée d'un matériau différent de celui du nanofeuillet initial.

Dans un mode de réalisation, la particule ou l'objet final peut comprendre le nanofeuillet initial et 2, 3, 4, 5 ou plus monocouches recouvrant tout ou partie du nanofeuillet initial, lesdites monocouches étant de composition différente de celle du nanofeuillet initial ou étant de composition différente entre elles.

Dans un mode de réalisation, la particule ou l'objet final peut comprendre le nanofeuillet initial et au moins 2, 3, 4, 5 ou plus monocouches, dans lequel la première monocouche déposée recouvre tout ou partie du nanofeuillet initial et la au moins deuxième monocouche déposée recouvre tout ou partie de la monocouche précédemment déposée, lesdites monocouches étant de composition différente de celle du nanofeuillet initial et pouvant être de composition différente entre elles.

Ainsi dans un mode de réalisation, la particule ou l'objet final comprend le nanofeuillet initial recouvert totalement par au moins une monocouche continue puis recouvert totalement ou partiellement par au moins une autre monocouche, lesdites monocouches étant de composition différente de celle du nanofeuillet initial et pouvant être de composition différente entre elles.

Dans un mode de réalisation, la particule ou l'objet final présente une structure coeur/coque, i.e. un nanofeuillet initial d'une composition donnée recouvert sur toute sa surface d'au moins une monocouche de composition différente de celle du nanofeuillet initial.

Ainsi, le matériau obtenu est composé d'un empilement de films dont au moins un est de composition chimique différente du nanofeuillet initial, la surface de chaque film couvrant totalement la surface du film sur lequel il est déposé.

Dans un mode de réalisation, la particule ou l'objet final présente une structure démouillée, i.e. un nanofeuillet initial d'une composition donnée recouvert en partie d'au moins une monocouche de composition différente de celle du nanofeuillet initial.

Ainsi, le matériau obtenu est composé d'un empilement de films dont au moins un est de composition chimique différente du nanofeuillet initial, la surface de chaque film couvrant partiellement la surface du film sur lequel il est déposé.

Dans des exemples, qui constituent des modes de réalisation selon l'invention uniquement dans les limites de la revendication 1, le matériau composant la au moins une monocouche comprend un matériau M ou E, où
M est Zn, Cd, Hg, ou un mélange de ceux-ci, et
E est S, Se, Te ou un mélange de ceux-ci, ou ME est ZnO, CdO ou HgO.

Dans un mode de réalisation où la particule ou l'objet final comprend au moins une couche, i.e. au moins 2 monocouches (2 monocouches étant également définies comme une bicouche), ladite couche comprend un composant du groupe II-VI.

Dans un mode de réalisation où la particule ou l'objet final comprend au moins une couche, i.e. au moins 2 monocouches (2 monocouches étant également définies comme une bicouche), ladite couche comprend au moins un semi-conducteur choisi parmi CdS, CdSe, CdTe, ZnS, ZnSe, ZnTe, HgS, HgSe, HgTe, ou un mélange de ceux-ci.

Dans un mode de réalisation, le matériau composant la au moins une couche comprend au moins un semi-conducteur choisi préférentiellement parmi CdS, CdSe, CdTe, ZnS, ZnSe, ZnTe.

Dans un mode de réalisation, le nanofeuillet initial est un nanofeuillet colloïdal inorganique.

Dans un mode de réalisation, le nanofeuillet initial est cristallin.

Dans un mode de réalisation, la particule ou l'objet final est un nanofeuillet.

Dans un mode de réalisation, la particule ou l'objet final est inorganique.

Dans un mode de réalisation, la particule ou l'objet final est colloïdal.

Dans un mode de réalisation, la particule ou l'objet final est cristallin.

Dans un mode de réalisation, le nanofeuillet initial compris dans la particule ou l'objet final a conservé sa structure quasi-2D.

Dans un mode de réalisation, le matériau recouvrant le nanofeuillet initial est inorganique.

La présente invention a pour objet un procédé de croissance en épaisseur selon la revendication 5.

Dans un mode de réalisation, le matériau composant le nanofeuillet initial comprend un matériau ME où
M est Zn, Cd, Hg,
E est S, Se, Te.

Dans un mode de réalisation, le matériau semi-conducteur composant le nanofeuillet initial comprend un composant du groupe II-VI,.

Dans un mode de réalisation, le matériau composant le nanofeuillet initial comprend au moins un semi-conducteur choisi parmi CdS, CdSe, CdTe, ZnS, ZnSe, ZnTe, HgS, HgSe, HgTe.

Dans un mode de réalisation, le matériau composant le nanofeuillet initial comprend au moins un semi-conducteur choisi préférentiellement parmi CdS, CdSe, CdTe, ZnS, ZnSe, ZnTe.

Dans un mode de réalisation, le précurseur de l'élément R à déposer est introduit en quantité au moins suffisante pour être en proportions stoechiométriques avec les atomes de surface du ou des nanofeuillets.

Dans un mode de réalisation, le précurseur de l'élément R à déposer est introduit en quantité sous-stoechiométriques (de façon à recouvrir partiellement le nanofeuillet initial ou la couche précédente).

Dans un mode de réalisation, on met en oeuvre les deux, ou optionnellement trois, étapes du procédé précédent n fois où n est un entier supérieur ou égal à 1.

Dans un mode de réalisation, l'élément R successivement mis en oeuvre ci-dessus peut être de composition différente.

Dans un mode de réalisation où l'on met en oeuvre une fois (n=1) les deux, ou optionnellement trois, étapes du procédé telles que décrites ci-dessus, l'élément R est soit M soit E et le précurseur de l'élément R est respectivement soit un précurseur de M soit un précurseur de E, en fonction de la composition du nanofeuillet initial,
où M est Zn, Cd, Hg, ou un mélange de ceux-ci,
E est S, Se, Te, ou un mélange de ceux-ci, ou ME est ZnO, CdO ou HgO.

Dans un mode de réalisation où l'on met en oeuvre plusieurs fois (n>1) les deux, ou optionnellement trois, étapes du procédé telles que décrites ci-dessus, l'élément R déposé en premier est soit M soit E, l'élément R déposé en second est E si l'élément R déposé en premier est M ou M si l'élément R déposé en premier est E, et ainsi de suite.

Dans un mode de réalisation où l'on met en oeuvre plusieurs fois (n>1) les deux, ou optionnellement trois, étapes du procédé telles que décrites ci-dessus, on alterne systémiquement le dépôt d'une monocouche M et d'une monocouche E ou inversement.

Ainsi, dans un mode de réalisation où l'on met en oeuvre deux fois (n=2) les deux, ou optionnellement trois, étapes du procédé telles que décrites ci-dessus, une bicouche M₁E₁ ou E₁M₁ est formée sur le nanofeuillet initial.

Dans un mode de réalisation où l'on met en oeuvre trois fois (n=3) les deux, ou optionnellement trois, étapes du procédé telles que décrites ci-dessus, une bicouche M₁E₁ ou E₁M₁ est formée sur le nanofeuillet initial puis une monocouche E₂ ou M₂, ledit E₂ ou M₂ étant identique ou différent en composition de E₁ ou M₁.

Dans un mode de réalisation où l'on met en oeuvre quatre fois (n=4) les deux, ou optionnellement trois, étapes du procédé telles que décrites ci-dessus, une bicouche M₁E₁ ou E₁M₁ est formée sur le nanofeuillet initial puis une bicouche M₂E₂ ou E₂M₂ respectivement, lesdits E₂ ou M₂ étant identiques ou différents en composition de E₁ ou M₁.

Ainsi, dans un mode de réalisation où l'on met en oeuvre n fois les deux, ou optionnellement trois, étapes du procédé telles que décrites ci-dessus,
lorsque n est impair :
   le nanofeuillet initial est recouvert par (n-1)/2 bicouche(s) toute(s) ME ou toute(s) EM puis une monocouche M ou E respectivement, les éléments M et E pouvant être de composition identique ou différente,
lorsque n est pair :
   le nanofeuillet initial est recouvert par n/2 bicouche(s) ME ou EM, les éléments M et E pouvant être de composition identique ou différente.

Dans un mode de réalisation, les bicouches ME ou EM formées correspondent à un composant du groupe II-VI.

Dans un mode de réalisation, les bicouches ME ou EM formées correspondent à au moins un semi-conducteur choisi parmi CdS, CdSe, CdTe, ZnS, ZnSe, ZnTe, HgS, HgSe, HgTe, , ou un mélange de ceux-ci ou CdO, ou ZnO.

Dans un mode de réalisation, le matériau composant la au moins une monocouche E comprend au moins un matériau choisi parmi S, Se, Te, , ou un mélange de ceux-ci.

Dans un mode de réalisation, les bicouches ME ou EM formées correspondent à au moins un semi-conducteur choisi préférentiellement parmi CdS, CdSe, CdTe, ZnS, ZnSe, ZnTe.

Dans un mode de réalisation, on dépose en surface d'au moins un nanofeuillet colloïdal inorganique une monocouche cationique (M) puis une monocouche anionique (E) ou inversement, ce qui forme une bicouche de composition ME constituée des éléments M et E en rapport stoechiométrique.

Dans un mode de réalisation, on répète la séquence de dépôts ci-dessus m fois où m est un entier au moins égal à 1 ce qui forme un film de composition ME.

Dans un mode de réalisation, le temps t de réaction du précurseur de R est inférieur à quelques heures, préférentiellement inférieur à 24 heures, ou inférieur à 12 heures, ou inférieur à 6 heures, ou inférieur à 4 heures, ou inférieur à 2 heures, ou inférieur à 1 heure.

Dans un mode de réalisation, le temps t de réaction du précurseur de R est compris entre une milliseconde et une minute.

Dans un mode de réalisation, le film déposé est un alliage des matériaux précédemment cités.

Dans un mode de réalisation, le film de composition ME déposé est un chalcogénure.

Dans un mode de réalisation, le film de composition ME déposé est un phosphure.

Dans un mode de réalisation, le film de composition ME déposé est un oxyde.

Dans un mode de réalisation, le film déposé contient un métal de transition ou un lanthanide en quantité minoritaire (dopage).

Dans un mode de réalisation, le film déposé contient en petites quantités un élément produisant un excès ou un déficit d'électrons par rapport au film seul (dopage électronique).

Dans un mode de réalisation, le ou les nanofeuillets initiaux peuvent être fixés sur au moins un substrat.

Dans un mode de réalisation, la fixation du ou des nanofeuillets sur le au moins un substrat est réalisée par adsorption ou par couplage chimique.

Dans un mode de réalisation, le dit substrat est choisi parmi la silice SiO₂, l'alumine Al₂O₃, l'oxyde d'indium-étain ITO, l'oxyde d'étain dopé au fluor (FTO), l'oxyde de titane TiO₂, l'or, l'argent, le nickel, le molybdène, l'aluminium, le silicium, le germanium, le carbure de silicium SiC, le graphène et la cellulose.

Dans un mode de réalisation, le dit substrat est un polymère.

Dans un mode de réalisation, le nanofeuillet initial est dispersé dans un solvant de dispersion.

Dans un mode de réalisation, le milieu de dispersion est un milieu organique, de préférence apolaire ou faiblement polaire.

Dans un mode de dispersion, le solvant de dispersion des nanofeuillets est choisi parmi l'eau distillée, le méthanol, l'éthanol, l'isopropanol, le butanol, le chloroforme, l'acétone, l'hexane, le tétrahydrofurane, le diméthylsulfoxyde, le toluène, l'octadécène, et le diméthylformamide.

Dans un mode de réalisation, le solvant de dispersion des nanofeuillets est un fluide supercritique.

Dans un mode de dispersion, le solvant de dispersion des nanofeuillets est un liquide ionique.

Dans un mode de réalisation, un composé de stabilisation apte à stabiliser le ou les particules ou objets finaux en solution peut être introduit dans le solvant de dispersion.

Dans un mode de réalisation, le composé de stabilisation des particules ou objets finaux comprend un ligand organique.

Dans un mode de réalisation, le ligand organique comprend un acide carboxylique, un thiol, une amine, une phosphine, un amide, un ester, une pyridine, un imidazole, un alcool.

Dans un mode de réalisation, le composé de stabilisation du ou des particules ou objets finaux est un ion.

Dans un mode de réalisation, l'ion de stabilisation comprend un ammonium quaternaire.

Dans un mode de réalisation, la température du milieu réactionnel est de 40°C à 80°C, d'environ 60°C (60°C ± 5°C).

Dans un mode de réalisation, la température du milieu réactionnel est la température ambiante.

Dans un mode de réalisation, un procédé de recuit est mis en place afin de diminuer la rugosité de surface de la particule ou de l'objet final.

Dans un mode de réalisation, l'excédent de précurseur est éliminé après réaction.

Dans un mode de réalisation, on purifie les nanofeuillets après réaction du précurseur de R sur ceux-ci.

Dans un mode de réalisation, la purification est réalisée par floculation et/ou précipitation.

Dans un mode de réalisation, la purification est réalisée par filtration.

Dans un mode de réalisation, si R est un chalcogène, le précurseur de R est un composé contenant le chalcogène au degré d'oxydation -2.

Dans un mode de réalisation, si R est du soufre, le précurseur de R est un sel contenant des ions sulfure S²⁻ .

Dans un mode de réalisation, le précurseur de R comprend le sulfure de bis(triméthylsilyle) (TMS₂S) ou le sulfure d'hydrogène (H₂S) ou l'hydrogénosulfure de sodium (NaSH) ou le sulfure de sodium (Na₂S), ou le sulfure d'ammonium (S(NH4)₂), ou la thiourée, ou la thioacétamide.

Dans un mode de réalisation, si R est du sélénium, le précurseur de R est un sel contenant les ions séléniure Se²⁻ .

Dans un mode de réalisation, le précurseur de R est le séléniure de bis(triméthylsilyle) (TMS₂Se) ou le séléniure d'hydrogène (H₂Se) ou le séléniure de sodium (Na₂Se) ou l'hydrogénoséléniure de sodium (NaSeH) ou le séléniosulfate de sodium (Na₂SeSO₃), ou la sélénourée.

Dans un mode de réalisation, si R est du tellure, le précurseur de R est un sel contenant des ions tellurure Te²⁻.

Dans un mode de réalisation, le précurseur de R est le tellurure de bis(triméthylsilyle) (TMS₂Te) ou le tellurure d'hydrogène (H₂Te) ou le tellurure de sodium (Na₂Te) ou l'hydrogénotellurure de sodium (NaTeH) ou le tellurosulfate de sodium (Na₂TeSO₃).

Dans un mode de réalisation, si R est un chalcogène, le précurseur de R est formé in-situ par réaction d'un réducteur avec un composé contenant R au degré d'oxydation 0 ou à un degré d'oxydation strictement positif.

Dans un mode de réalisation, si R est un métal, le précurseur de R est un composé contenant le métal dans un degré d'oxydation positif ou nul.

Dans un mode de réalisation, si R est un métal, le précurseur de R comprend un sel métallique.

Dans un mode de réalisation, le sel métallique est un carboxylate de R, ou un chlorure de R, ou un nitrate de R, ou un sulfate de R, ou un thiolate de R.

Dans un mode de réalisation, si R est de l'oxygène le précurseur de R est l'ion hydroxyde (HO⁻).

Dans un mode de réalisation, si R est de l'oxygène le précurseur de R est une solution de soude (NaOH) ou de potasse (KOH) ou d'hydroxyde de tétraméthylammonium (TMAOH).

Dans un mode de réalisation, un réducteur peut être introduit en même temps que le ou les précurseurs du film à déposer.

Dans un mode de réalisation, le réducteur comprend un hydrure.

Dans un mode de réalisation, le réducteur comprend du dihydrogène.

Dans un mode de réalisation, l'hydrure comprend le tétrahydruroborate de sodium (NaBH₄), l'hydrure de sodium (NaH), le tétrahydruroaluminate de lithium (LiAlH₄), l'hydrure de diisobutylaluminium (DIbAlH).

La présente invention a également pour objet l'utilisation des particules ou objets finaux tels que décrits ci-dessus.

En effet, ces particules ou objets finaux accrus ultérieurement dans l'épaisseur présentent de nombreuses propriétés et avantages telles que un rendement quantique élevé, une stabilité accrue, une meilleure stabilité de surface, une faible largeur à mi-hauteur de fluorescence (moins de 30nm, de préférence moins de 25nm), un temps de vie de fluorescence rapide (moins de 40 ns, de préférence moins de 10ns), une section efficace d'absorption importante (environ ou plus de 10⁻¹³ cm² à 400nm), un réglage possible de la longueur d'onde d'émission, une robustesse dans le temps des propriétés optiques, une grande surface spécifique.

Ces différentes propriétés font des particules ou objets finaux tels que décrits ci-dessus des objets très utiles pour des applications en fluorescence, notamment dans les systèmes luminescents, électroluminescents ou les étages d'amplification d'un laser.

A titre d'exemple, les nanofeuillets de CdSe recouverts d'une coque de CdS ou de CdZnS tels que décrits dans les exemples présentent un rendement quantique élevé qui peut être de plus de 60% ainsi qu'une largeur à mi-hauteur de l'émission de fluorescence étroite (moins de 20 nm). D'autres exemples de particules ou objets finaux utiles pour des applications en fluorescence sont les nanofeuillets de CdS recouverts de ZnS (CdS/ZnS), les nanofeuillets en CdSeₓS_{1-X} (x étant un nombre décimal variant de 0 à 1) recouverts de Cd_{y}Zn_{1-y}S (y étant un nombre décimal variant de 0 à 1) (CdSeS/CdZnS), les nanofeuillets en CdSeₓS_{1-X} (x étant un nombre décimal variant de 0 à 1) recouverts de ZnS (CdSeS/ZnS), les nanofeuillets en CdTe recouverts de Cd_{y}Zn_{1-y}SeₓS₁₋ₓ ((x et y étant des nombres décimaux variant de 0 à 1 indépendamment) (CdTe/CdZnSeS), les nanofeuillets de CdS recouverts de ZnS dopé au manganèse II ou au cuivre II CdS/ZnS :Mn ou CdS/ZnS :Cu.

Ces particules ou objets finaux tels que décrits ci-dessus sont également très utiles en tant que catalyseurs du fait de leur grande surface spécifique, leur stabilité accrue, leur section efficace d'absorption importante.

Ces particules ou objets finaux tels que décrits ci-dessus sont également très utiles en tant qu'élément absorbeur et/ou collecteur d'une cellule photovoltaïque, du fait de leur stabilité accrue, d'une mobilité électrons/trous augmentée et d'une section efficace d'absorption importante.

A titre d'exemple, des nanofeuillets de CdSe de dimensions importantes (plus de 100 nm de dimensions latérales) peuvent être recouverts d'une coque dopée (CdZnS dopée Ag⁺ par exemple). Ce qui permet d'augmenter la mobilité électronique des éléments absorbeurs et collecteurs d'une cellule solaire contenant de tels objets finaux : CdSe/CdTe, CdTe/CdSe selon l'invention ou PbSe/PbS, ZnS/InP, CuInS₂/ZnS, CdS/CuInS₂ à titre d'illustration.

Ces particules ou objets finaux tels que décrits ci-dessus sont également très utiles en tant que transistor à effet de champ du fait de leur stabilité accrue, d'une mobilité électrons/trous augmentée et d'une densité de porteurs de charge importante.

A titre d'exemple, des nanofeuillets de CdSe de dimensions importantes (plus de 100 nm de dimensions latérales) peuvent être recouverts d'une coque dopée (CdZnS dopée Ag⁺ par exemple). Ce qui permet d'augmenter la mobilité électronique au sein des objets finaux. De même, un feuillet de semiconducteur de bande interdite faible recouvert d'une coque de semiconducteur de bande interdite importante permet d'obtenir une mobilité élevée tout en conservant une structure excitonique. Des nanofeuillet en PbS recouvert d'une couche en CdS est un exemple de particules ou objets finaux utiles pour des applications de transistors à effet de champ.

Un autre aspect de l'invention concerne un système luminescent, électroluminescent, ou un étage d'amplification d'un laser, un catalyseur à grande surface spécifique et cristallinité de surface contrôlée, un élément absorbeur et/ou collecteur d'une cellule photovoltaïque ou un transistor à effet de champ comportant un matériau obtenu du procédé selon un mode de réalisation de l'invention.

D'autres caractéristiques et avantages du procédé selon l'invention apparaitront à la lecture de la description détaillée et des exemples de réalisation donnés ci-après à titre purement illustratif.

### BRÈVE DESCRIPTION DES FIGURES

La figure 1 montre un schéma fonctionnel des étapes d'un procédé de croissance en épaisseur selon un mode de réalisation de l'invention.
La figure 2 montre la structure cristalline d'un feuillet de CdSe vu en coupe selon un mode de réalisation de l'invention.
La figure 3 montre la structure schématique d'un feuillet hétéro-structuré vu en coupe selon un mode de réalisation de l'invention.
La figure 4 montre la structure schématique d'un feuillet hétéro-structuré obtenu par croissance après immobilisation sur un substrat vu en coupe selon un mode de réalisation de l'invention.

### EXEMPLES

La présente invention se comprendra mieux à la lecture des exemples suivants qui illustrent non-limitativement l'invention.

### Feuillets initiaux:

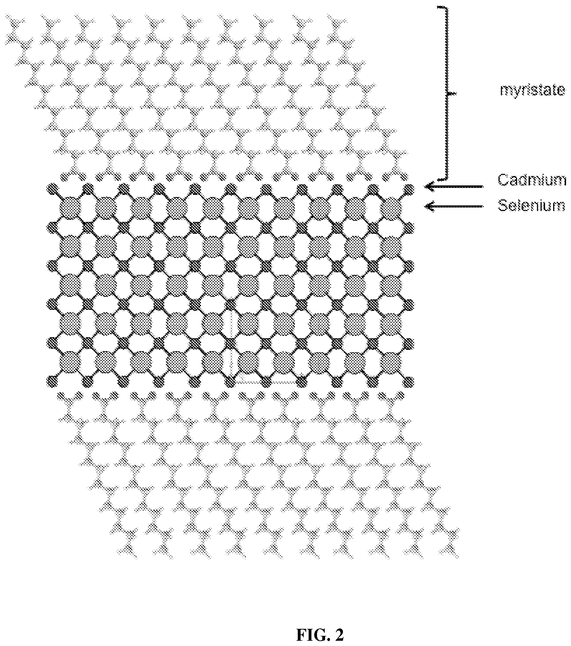

Les feuillets initiaux sur lesquels le procédé de croissance en épaisseur est particulièrement efficace sont, selon au moins un mode de réalisation de l'invention, les feuillets présentant une charge nette de surface. Cette charge nette de surface peut être positive ou négative suivant la nature du feuillet considéré. Les feuillets de semi- conducteur tels que décrits ci-dessus (par exemple CdSe, CdS ou CdTe) font partie de cette classe de matériaux et seront pris comme exemples non limitatifs de feuillets initiaux. Un tel feuillet dont la structure est schématisée sur la figure 2 a une structure zinc-blende, d'axe de zone [0, 0, 1] et présente une surface cationique stabilisée par des carboxylates sur chaque face du feuillet. Ces faces sont parfaitement polaires (dans ce cas, cationiques).

Les feuillets de CdSe par exemple peuvent êtres obtenus par toute méthode connue, tel que décrit par exemple dans les documents suivants : Ithurria, S.; Dubertret, B. Journal of the American Chemical Society 2008, 130, 16504-5 et Ithurria, S.; Bousquet, G.; Dubertret, B. Journal of the American Chemical Society 2011, 133, 3070-7. 174mg de Cd(myristate)₂ et 12mg de Sélénium en poudre sont introduits dans un ballon tricol contenant 16mL d' 1-octadecene (ODE, 90%). Le ballon est dégazé sous pression réduite et sous agitation à température ambiante durant 30 minutes. De l'Argon est introduit dans le ballon qui est alors chauffé. Quand la température atteint 200°C, 40mg de Cd(Acétate)₂(H2O)₂ sont rapidement introduits dans le milieu réactionnel induisant la croissance des feuillets. Le milieu réactionnel est porté à 240°C, température à laquelle il est maintenu pendant environ 10 minutes afin d'assurer la croissance des feuillets. La solution est alors refroidie et lavée par précipitations et suspensions successives. La première précipitation est effectuée par ajout d'un non solvant : l'éthanol (80mL environ) et centrifugation (5000 tours par minute pendant 10minutes). Le surnageant est éliminé et le précipité suspendu dans de l'hexane (10mL environ). La solution de feuillets contient encore une grande quantité de Cd(myristate)₂ utilisé en excès. L'ajout de quelques millilitres d'octylamine (4mL) permet sa dissolution. La suspension de plaquettes est alors précipitée une deuxième fois par ajout d'éthanol (80mL) et centrifugation. Le procédé de suspension/ précipitation est répété encore 2 fois avec de l'octylamine puis une dernière fois simplement par suspension dans l'hexane et précipitation à l'éthanol. Le précipité final est suspendu dans 10mL de chloroforme (CHCl₃). Les feuillets obtenus présentent la structure schématisée figure 2, qui montre la structure cristalline d'un feuillet de CdSe vu en coupe.

### Dépôt d'un film de chalcogènure sur les feuillets

Les feuillets colloïdaux CdSe/CdS, selon au moins un mode de réalisation de l'invention, sont préparés par déposition couche par couche de CdS sur les feuillets initiaux de CdSe.

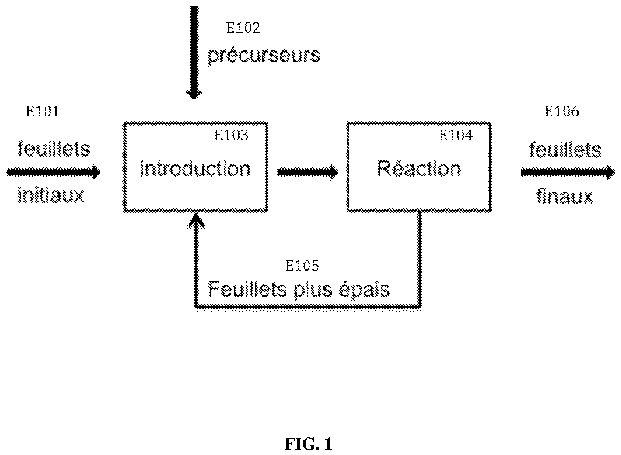

Les étapes du procédé mis en oeuvre sont résumées sur le schéma fonctionnel présenté figure 1.

Dans un premier mode de réalisation de l'invention le précurseur du soufre comprend le sulfure de Bis(triméthylsilyle) (TMS₂S). 2mL de la solution de feuillets de CdSe dans le chloroforme sont placés sous agitation magnétique dans une boite à gants sous atmosphère inerte (E101). 100µL de sulfure de Bis(triméthylsilyle) (TMS₂S)(E102) sont alors injectés dans la solution contenant les feuillets (E103), induisant un changement de couleur et une agrégation rapide. Le mélange est laissé à réagir une heure à température ambiante (E104). La solution est alors centrifugée, le surnageant supprimé et le précipité rincé deux fois à l'éthanol. Les feuillets composant le précipité (E105) sont plus épais que les feuillets initiaux, ils présentent une monocouche de soufre supplémentaire de chaque côté du CdSe initial. Le précipité (E105) est alors dispersé dans quelques millilitres d'hexane auxquels 10 mg de Cd(Acétate)₂(H2O)₂ en poudre (E101) sont ajoutés (E103). Sous agitation, on observe un nouveau changement de couleur, la réaction est laissée se poursuivre durant une heure (E104). 200µL d'acide oléique sont alors ajoutés, la solution redevient limpide. Les feuillets finaux (E106) sont alors précipités à l'éthanol et suspendus dans l'hexane. Ce procédé permet le dépôt d'une monocouche de CdS de chaque côté des feuillets de CdSe.

Dans un second mode de réalisation de l'invention le précurseur du soufre comprend le sulfure d'hydrogène H₂S. 2mL de la solution de feuillets de CdSe dans CHCl₃ (E101) sont placés sous agitation magnétique dans une boite à gants. 2mmoles d'H₂S (48mL) (E102) sont bullés (E103) dans la solution. Celle-ci change de couleur et se trouble immédiatement (E104). Les feuillets agrégés sont précipités par centrifugation, le surnageant est supprimé et le précipité est dispersé dans l'hexane (E105). 10mg de Cd(Acétate)₂(H2O)₂ (E102) y sont ajoutés (E103) et provoquent un nouveau changement de couleur (E104). Après une heure, 200µL d'acide oléique sont ajoutés et la solution redevient limpide, signe de la désagrégation des feuillets. Les feuillets finaux (E106) sont alors précipités à l'éthanol, centrifugés et suspendus dans l'hexane. Ce procédé permet le dépôt d'une monocouche de CdS de chaque côté des feuillets de CdSe.

Dans un troisième mode de réalisation de l'invention le précurseur du soufre comprend le sulfure d'ammonium. 2mL de la solution de feuillets de CdSe dans CHCl₃ (E101) ainsi que 2mL de solution aqueuse d'hydroxyde de tétraméthylammonium (100mg/mL) sont introduits dans un pilulier. 100µL de solution aqueuse de sulfure d'ammonium (20%, E102) sont rapidement injectés dans le mélange biphasique (E103). La couleur de la phase organique contenant les feuillets change immédiatement (E104). Sous agitation, les feuillets se transfèrent alors en quelques minutes dans la phase aqueuse supérieure. L'ajout de 10mL d'éthanol casse le mélange diphasique et induit l'agrégation des feuillets qui sont alors précipités par centrifugation. Le surnageant est supprimé et les feuillets suspendus dans de l'eau distillée (E105). 20mg de Cd(Acétate)₂(H2O)₂ (E102) sont ajoutés à la solution (E103), ce qui entraîne un changement de couleur immédiat suivit de l'agrégation des feuillets (E104). Les feuillets finaux (E106) sont précipités par centrifugation et dispersés dans l'hexane à l'aide de 200µL d'acide oléique. Ce procédé a permis le dépôt d'une monocouche de CdS de chaque côté des feuillets de CdSe.

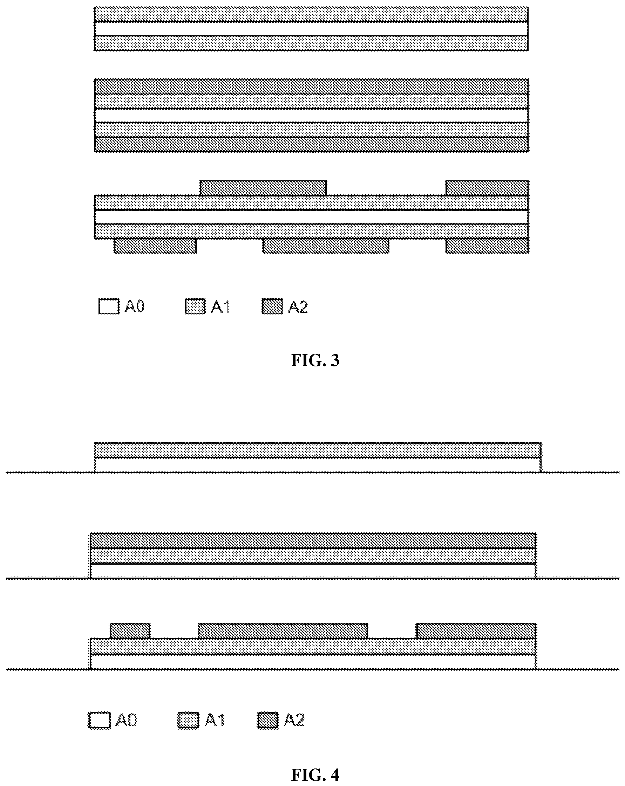

L'itération du processus décrit dans l'un quelconque des modes de réalisation ci-dessus permet de déposer des couches supplémentaires. La structure finale des feuillets obtenus est schématisée figure 3, ou A0 est le CdSe, et A1 est le CdS. Le remplacement du Cd(Acétate)₂(H2O)₂ par du Zn(Acétate)₂(H2O)₂ permet de déposer une monocouche de ZnS sur les feuillets de CdSe.

Les mêmes procédés peuvent être utilisés pour déposer un séléniure ou un tellurure à la place du sulfure. Dans ce cas le précurseur utilisé pourra être l'analogue au sélénium ou au tellure des précurseurs utilisés ci-dessus.

### Dépôt d'un film d'oxyde sur les feuillets.

On décrit par exemple le dépôt d'oxyde de zinc ZnO, selon un mode de réalisation de l'invention, sur des feuillets initiaux de CdSe. 2mL de la solution de feuillets de CdSe dans CHCl₃ (E101) sont introduits dans un pilulier. 100µL d'une solution d'hydroxyde de tétraméthylammonium (E102) dans le méthanol y sont injectés (E103). La couleur de la solution passe immédiatement de jaune à rouge et les feuillets s'agrègent fortement (E104). Les feuillets (E105) sont alors précipités par centrifugation et lavés deux fois a l'éthanol. Les feuillets (E105) sont alors dispersés dans le chloroforme et 10 mg de Zn(stéarate)₂ (E101) y sont ajoutés. Après 10 minutes de sonication (E104), les feuilletsfinaux (E106) sont précipités à l'éthanol et suspendus dans le chloroforme. Ce procédé permet le dépôt d'une monocouche de ZnO de chaque côté des feuillets de CdSe. La structure finale des feuillets obtenus est schématisée figure 3, ou A0 est le CdSe, et A1 est le ZnO.

### Dépôt d'un film métallique

On décrit par exemple le dépôt d'or, selon un mode de réalisation de l'invention, sur des feuillets initiaux de CdSe Ces derniers présentant une charge de surface positive, il est tout d'abord nécessaire d'inverser celle-ci. On effectue cette inversion par dépôt d'une monocouche de soufre en surface des feuillets.

2mL de la solution de feuillets de CdSe dans CHCl₃ (E101) ainsi que 100µL de solution de sulfure de tétraméthylammonium (1 M) dans l'éthanol sont introduits dans un pilulier. Sous agitation la couleur de la solution contenant les feuillets change immédiatement et ceux-ci s'agrègent. Après 10 minutes de réaction, les feuillets sont précipités par centrifugation. Le surnageant est supprimé et les feuillets lavés deux fois à l'éthanol. Les feuillets sont suspendus dans de l'eau distillée.

On ajoute alors goutte à goutte (E103) dans la solution de feuillets une solution de HAuCl₄ (E102) à 0,1M. La couleur de la solution change progressivement du fait du dépôt de l'or en surface des feuillets (E104). Les feuillets finaux (E106) sont lavés deux fois par précipitation à l'éthanol. La structure finale des feuillets obtenus est schématisée figure 3, ou A0 est le CdSe, et A1 est de l'or (Au).

Selon un autre mode de réalisation de l'invention, on décrit par exemple le dépôt d'une couche d'or sur les nanofeuillets initiaux.

Dans un pilulier sont introduits successivement 2mL de chloroforme, 400 µL de la solution de feuillets de CdSe, 20mg de thioacétamide (TAA) ainsi que 200 µL d'octylamine. La solution est soumise à sonication pendant cinq minutes, ce qui entraine la dissolution complète du TAA ainsi qu'un changement de couleur de la solution de jaune à orange. Les feuillets sont alors agrégés par ajout de quelques gouttes d'éthanol el la solution est centrifugée 5 minutes à 5000 tours/min. Le surnageant contenant les précurseurs n'ayant pas réagit est supprimé et le culot formé par les feuillets est dispersé dans 2mL de toluène. On y ajoute alors 2mL d'une solution de précurseurs d'or et de ligands préparée par dissolution dans 10mL de toluène de 10mg d'AuCl₃, 80mg de bromure de didodecyldimethylammonium ainsi que 120mg de dodecylamine. Le mélange est laissé à réagir durant quinze minutes. Les objets coeur/coque résultant sont précipités par centrifugation 5 minutes à 5000 tours/min, les surnageant est supprimé et le culot dispersé dans 2mL de toluène.

### Dépôt d'un film d'un alliage

On décrit par exemple le dépôt, selon un mode de réalisation de l'invention, d'un alliage de sulfure de cadmium et de sulfure de zinc CdZnS sur des feuillets initiaux de CdSe.

2mL de la solution de feuillets de CdSe (E101) dans le chloroforme sont placés sous agitation magnétique dans une boite à gants sous atmosphère inerte. 100µL de sulfure de Bis(triméthylsilyle) (TMS₂S) (E102) y sont alors injectés (E103), induisant un changement de couleur et une agrégation rapide. Le mélange est laissé à réagir une heure à température ambiante (E104). La solution est alors centrifugée, le surnageant supprimé et le précipité rincé deux fois à l'éthanol. Celui-ci est alors dispersé dans quelques millilitres d'hexane (E105). Une solution de 5 mg de Cd(Acétate)₂(H2O)₂ (E102) et de 3.5mg de Zn(Acétate)₂ (E102) dissous dans 1 mL d'éthanol est ajoutée goutte à goutte en dix minutes (E103). On observe un nouveau changement de couleur, la réaction est laissée se poursuivre sous agitation durant une heure (E104). 200µL d'acide oléique sont alors ajoutés, la solution redevient limpide. Les feuillets finaux (E106) sont alors précipités à l'éthanol et suspendus dans l'hexane. Ce procédé permet le dépôt d'une monocouche de Cd_{0,5}Zn_{0,5}S de chaque coté des feuillets de CdSe. L'itération du procédé permet de déposer des couches supplémentaires. La structure finale des feuillets obtenus est schématisée figure 3, ou A0 est le CdSe, et A1 est le CdZnS.

### Dépôt d'un film dopé

On décrit par exemple le dépôt d'un film de sulfure de zinc dopé au manganèse sur des feuillets initiaux de CdS selon un mode de réalisation de l'invention.

2mL d'une solution de feuillets de CdS (E101) dans le chloroforme sont placés dans un pilulier sous agitation magnétique dans une boite à gants sous atmosphère inerte. 100µL de sulfure de Bis(triméthylsilyle) (TMS₂S, E102) y sont alors injectés (E103), induisant une agrégation rapide. Le mélange est laissé à réagir une heure à température ambiante (E104). La solution est alors centrifugée, le surnageant supprimé et le précipité rincé deux fois à l'éthanol. Celui-ci est alors dispersé dans quelques millilitres d'hexane (E105). 1mL d'une solution de Zn(Acétate)₂ et de Mn(Acétate)₂ (1% molaire en Mn) dans d'éthanol (E102) est ajoutée goutte à goutte en dix minutes (E103). La réaction est laissée se poursuivre sous agitation durant une heure (E104). 200µL d'acide oléique sont alors ajoutés, la solution redevient limpide. Les feuillets finaux (E106) sont alors précipités à l'éthanol et suspendus dans l'hexane. Ce procédé permet le dépôt d'une monocouche de ZnS dopé au manganèse de chaque coté des feuillets initiaux de CdS. L'itération du processus permet de déposer des couches supplémentaires.

### Dépôt successif de plusieurs films de composition chimique différente

On décrit par exemple le dépôt d'un film de sulfure de cadmium puis de sulfure de zinc sur des feuillets initiaux de CdS selon un mode de réalisation de l'invention.

2mL de la solution de feuillets de CdSe dans le chloroforme (E101) sont placés sous agitation magnétique dans une boite à gants sous atmosphère inerte. 100µL de sulfure de Bis(triméthylsilyle) (TMS₂S, E102) y sont alors injectés (E103), induisant un changement de couleur et une agrégation rapide. Le mélange est laissé à réagir une heure à température ambiante (E104). La solution est alors centrifugée, le surnageant supprimé et le précipité rincé deux fois à l'éthanol. Celui-ci (E105) est alors dispersé dans quelques millilitres d'hexane auquel 10 mg de Cd(Acétate)₂(H2O)₂ (E102) en poudre sont ajoutés (E103). Sous agitation, on observe un nouveau changement de couleur, la réaction est laissée se poursuivre durant une heure (E104). 200µL d'acide oléique sont alors ajoutés, la solution redevient limpide. Les feuillets sont alors précipités à l'éthanol et suspendus dans 2mL de chloroforme. On a maintenant des feuillets recouverts d'une monocouche de CdS (E105). Cette solution est de nouveau placée sous agitation magnétique dans une boite à gants sous atmosphère inerte. 100µL de sulfure de Bis(triméthylsilyle) (TMS₂S, E102) y sont alors injectés (E103), induisant un changement de couleur et une agrégation rapide. Le mélange est laissé à réagir une heure à température ambiante (E104). La solution est alors centrifugée, le surnageant supprimé et le précipité rincé deux fois à l'éthanol. Celui-ci (E105) est alors dispersé dans quelques millilitres d'hexane auquel 10 mg de Zn(Acétate)₂ (E102) en poudre sont ajoutés (E103). Sous agitation, on observe un nouveau changement de couleur. La réaction est laissée se poursuivre durant une heure (E104). 200µL d'acide oléique sont alors ajoutés, la solution redevient limpide. Les feuillets finaux (E106) sont alors précipités à l'éthanol et suspendus dans l'hexane. La structure finale des feuillets obtenus est schématisée figure 3, ou A0 est le CdSe, A1 est le CdS et A2 est le ZnS.

### Immobilisation de feuillets sur substrat puis croissance :

Dans un mode de réalisation de l'invention, une lame de verre de microscope (26mm par 26mm) est nettoyée à l'aide d'un plasma d'oxygène. Elle est ensuite fonctionnalisée au 3-mercaptopropyl-triethoxysilane par immersion pendant 10 minutes dans une solution à 1% en volume de 3-mercaptopropyl-triethoxysilane dans l'éthanol. La lame de verre est rincée 3 fois à l'éthanol puis séchée. Elle est alors immergée durant 1 heure dans une solution de feuillets de CdSe dispersés dans du chloroforme. Les feuillets s'adsorbent à la surface de la lame de verre pour former une monocouche de feuillets. La lame est rincée 2 fois au chloroforme afin de supprimer les feuillets non liés au substrat.

On dépose alors une monocouche de soufre en surface des feuillets adsorbés sur la lame de verre. La lame recouverte de feuillets (E101) est placée dans une boite à gants sous atmosphère inerte et immergée dans du chloroforme. 10µL de sulfure de Bis(triméthylsilyle) (TMS₂S E102) y sont alors injectés (E103). Après une heure de réaction (E104), la lame est rincée deux fois au chloroforme puis deux fois à l'éthanol. Il est ensuite possible d'y déposer une monocouche de Cadmium afin de former un film de CdS. Pour cela, la lame de verre recouverte de feuillets plus épais (E105) est immergée (E103) dans une solution 0,1M de Cd(Acétate)₂(H2O)₂ (E102) dans l'éthanol et est laissée à réagir une heure (E104). Après deux rinçages à l'éthanol, la lame de verre est ainsi recouverte d'une couche de feuillets CdSe/CdS (E106). La structure finale des feuillets sur substrat obtenus est schématisée figure 4, ou A0 est le CdSe et A1 est le CdS.

Comme il va de soi et comme il résulte d'ailleurs déjà de ce qui précède, l'invention ne se limite nullement à ceux des modes d'applications et de réalisations qui ont été plus spécialement envisagés ; elle en embrasse au contraire toutes les variantes sans pour autant sortir du cadre de l'invention tel que défini par les revendications.

Bibliographie :
(1) Ekimov, A. JETP Lett 1981, 34, 345-348.
(2) Alivisatos, A. P. Science 1996, 271, 933-937.
(3) Vassiliou, J.; Mehrotra, V.; Russell, M. J. Appl. Phys 1993, 5109-5116.
(4) El-Sayed, M. a Accounts of chemical research 2004, 37, 326-33.
(5) Ma, R.; Sasaki, T. Advanced materials 2010, 22, 5082-104.
(6) Sasaki, T.; Watanabe, M. The Journal of Physical Chemistry B 1997, 101, 10159-10161.
(7) Hernandez, Y.; Nicolosi, V.; Lotya, M.; Blighe, F. M.; Sun, Z.; De, S.; McGovern, I. T.; Holland, B.; Byrne, M.; Gun'Ko, Y. K.; Boland, J. J.; Niraj, P.; Duesberg, G.; Krishnamurthy, S.; Goodhue, R.; Hutchison, J.; Scardaci, V.; Ferrari, A. C.; Coleman, J. N. Nature nanotechnology 2008, 3, 563-8.
(8) Vaughn, D. D.; Patel, R. J.; Hickner, M. a; Schaak, R. E. Journal of the American Chemical Society 2010, 132, 15170-2.
(9) Mehta, R. J.; Karthik, C.; Singh, B.; Teki, R.; Borca-Tasciuc, T.; Ramanath, G. ACS nano 2010, 4, 5055-60.
(10) Kumar, S.; Nann, T. Small 2006, 2, 316-29.
(11) Jun, Y.-wook; Choi, J.-sil; Cheon, J. Angewandte Chemie (International ed. in English) 2006, 45, 3414-39.
(12) Xu, S.; Sun, X.; Ye, H.; You, T.; Song, X.; Sun, S. Materials Chemistry and Physics 2010, 120, 1-5.
(13) Li, C. C.; Cai, W. P.; Cao, B. Q.; Sun, F. Q.; Li, Y.; Kan, C. X.; Zhang, L. D. Advanced Functional Materials 2006, 16, 83-90.
(14) Sigman, M. B.; Ghezelbash, A.; Hanrath, T.; Saunders, A. E.; Lee, F.; Korgel, B. a Journal of the American Chemical Society 2003, 125, 16050-7.
(15) Deng, Z.; Mansuripur, M.; Muscat, A. J. Journal of Materials Chemistry 2009, 19, 6201.
(16) Puntes, V. F.; Zanchet, D.; Erdonmez, C. K.; Alivisatos, a P. Journal of the American Chemical Society 2002, 124, 12874-80.
(17) Si, R.; Zhang, Y.-W.; You, L.-P.; Yan, C.-H. Angewandte Chemie (International ed. in English) 2005, 44, 3256-60.
(18) Zhang, G.; Sun, S.; Li, R.; Zhang, Y.; Cai, M.; Sun, X. Chemistry of Materials 2010, 22, 4721-4727.
(19) Sun, Y.; Xia, Y. Science 2002, 298, 2176-9.
(20) Ah, C. S.; Yun, Y. J.; Park, H. J.; Kim, W.-J.; Ha, D. H.; Yun, W. S. Chemistry of Materials 2005, 17, 5558-5561.
(21) Huang, W. L.; Chen, C.-hua; Huang, M. H. The Journal of Physical Chemistry C 2007, 111, 2533-2538.
(22) Deng, Z.; Mansuipur, M.; Muscat, A. J. The Journal of Physical Chemistry C 2009, 113, 867-873.
(23) Yu, T.; Joo, J.; Park, Y. I.; Hyeon, T. Journal of the American Chemical Society 2006, 128, 1786-7.
(24) Xu, R.; Xie, T.; Zhao, Y.; Li, Y. Crystal Growth & Design 2007, 7, 1904-1911.
(25) Yu, J. C.; Xu, A.; Zhang, L.; Song, R.; Wu, L. The Journal of Physical Chemistry B 2004, 108, 64-70.
(26) Joo, J.; Son, J. S.; Kwon, S. G.; Yu, J. H.; Hyeon, T. Journal of the American Chemical Society 2006, 128, 5632-3.
(27) Yu, J. H.; Liu, X.; Kweon, K. E.; Joo, J.; Park, J.; Ko, K.-T.; Lee, D. W.; Shen, S.; Tivakornsasithorn, K.; Son, J. S.; Park, J.-H.; Kim, Y.-W.; Hwang, G. S.; Dobrowolska, M.; Furdyna, J. K.; Hyeon, T. Nature materials 2010, 9, 47-53.
(28) Yu, S. H.; Yoshimura, M. Advanced Materials 2002, 14, 296-300.
(29) Li, J.; Xu, Y.; Wu, D.; Sun, Y. Solid State Communications 2004, 130, 619-622.
(30) Yao, W.-T.; Yu, S.-H.; Pan, L.; Li, J.; Wu, Q.-S.; Zhang, L.; Jiang, J. Small 2005, 1, 320-5.
(31) Fan, L.; Song, H.; Zhao, H.; Pan, G.; Yu, H.; Bai, X.; Li, S.; Lei, Y.; Dai, Q.; Qin, R.; Wang, T.; Dong, B.; Zheng, Z.; Ren, X. The journal of physical chemistry. B 2006, 110, 12948-53.
(32) Park, K. H.; Jang, K.; Son, S. U. Angewandte Chemie (International ed. in English) 2006, 45, 4608-12.
(33) Han-Mei, H.; Chong-Hai, D.; Xian-Huai, H.; Yan, L.; Mei, S.; Ke-Hua, Z. CHINE SE JOURNAL OF INORGANIC CHEMISTRY 2007, 23, 1403-1408.
(34) Huang, X.; Li, J. Journal of the American Chemical Society 2007, 129, 3157-62.
(35) Huang, X.; Li, J.; Zhang, Y.; Mascarenhas, A. Journal of the American Chemical Society 2003, 125, 7049-55.
(36) Son, J. S.; Wen, X.-D.; Joo, J.; Chae, J.; Baek, S.-L; Park, K.; Kim, J. H.; An, K.; Yu, J. H.; Kwon, S. G.; Choi, S.-H.; Wang, Z.; Kim, Y.-W.; Kuk, Y.; Hoffmann, R.; Hyeon, T. Angewandte Chemie (International ed. in English) 2009, 48, 6861-4.
(37) Ithurria, S.; Dubertret, B. Journal of the American Chemical Society 2008, 130, 16504-5.
(38) Ithurria, S.; Bousquet, G.; Dubertret, B. Journal of the American Chemical Society 2011, 133, 3070-7.
(39) Li, Z.; Peng, X. Journal of the American Chemical Society 2011, 133, 6578-86.
(40) Hines, M. a; Guyot-Sionnest, P. The Journal of Physical Chemistry 1996, 100, 468-471.
(41) Peng, X. Chemistry 2002, 8, 334-9.
(42) Trindade, T.; O'Brien, P.; Zhang, X.-mei Chemistry of Materials 1997, 9, 523-530.
(43) Mane, R. Materials Chemistry and Physics 2000, 65, 1-31.
(44) Nicolau, Y. Applications of Surface Science 1985, 22, 1061-1074.

## Revendications

1. Une particule colloïdale inorganique comprenant un nanofeuillet inorganique initial recouvert partiellement ou totalement par au moins deux monocouches de matériau inorganique, dans laquelle le nanofeuillet initial et les au moins deux monocouches sont composés d'au moins deux matériaux différents,
dans laquelle le matériau composant le nanofeuillet initial est choisi parmi CdSe, CdS, CdTe, ZnS, ZnSe, ZnTe, HgS, HgSe, ou HgTe, et dans laquelle les au moins deux monocouches sont alternées et composées de Q puis A ou inversement, où
Q est Zn, Cd, Hg, ou un mélange de ceux-ci, et A est S, Se, Te ou un mélange de ceux-ci, ou
QA est ZnO, CdO ou HgO, **caractérisée en ce que** les dimensions latérales du nanofeuillet initial représentent au moins 3 fois l'épaisseur du nanofeuillet initial.

2. Une particule selon la revendication 1, ayant une épaisseur de 0,5 nm à 10 mm.

3. Une particule selon la revendication 1 ou 2, dont les dimensions latérales représentent au moins 1,5 fois son épaisseur.

4. Une particule selon l'une quelconque des revendications 1 à 3, dans laquelle la particule colloïdale est choisie parmi CdSe/CdS, CdS/ZnS, CdTe/CdSe, CdSe/ZnO, CdTe/Cd_{y}Zn_{1-y}SeₓS₁₋ₓ, ou CdSe/Cd_{y}Zn_{1-y}S, x et y étant des nombres décimaux variant de 0 à 1 indépendamment.

5. Un procédé de croissance en épaisseur d'un nanofeuillet colloïdal inorganique par dépôt d'au moins un élément R sur au moins une face d'au moins un nanofeuillet colloïdal inorganique initial, conduisant à une particule colloïdale inorganique, le procédé comprenant les étapes suivantes :
(1) on met en présence au moins un nanofeuillet inorganique avec un précurseur de l'élément R à déposer, ce précurseur étant de degré d'oxydation positif si le nanofeuillet a une charge de surface négative et de degré d'oxydation négatif si le nanofeuillet a une charge de surface positive.
(2) on attend un temps t que le précurseur de R ait réagi avec les atomes de la surface du ou des nanofeuillets, pour former une monocouche de R,
dans lequel le précurseur de l'élément R est un précurseur de Q ou A,
où Q est Zn, Cd, Hg, ou un mélange de ceux-ci, et A est S, Se, Te, ou un mélange de ceux-ci, ou
QA est ZnO, CdO ou HgO,
dans lequel le matériau composant le nanofeuillet inorganique initial est choisi parmi CdSe, CdS, CdTe, ZnS, ZnSe, ZnTe, HgS, HgSe, ou HgTe,
dans lequel le nanofeuillet inorganique est recouvert totalement ou partiellement par au moins deux monocouches et dans laquelle les au moins deux monocouches sont alternées et composées de Q puis A ou inversement,
dans lequel le nanofeuillet inorganique initial et les au moins deux monocouches sont composés d'au moins deux matériaux différents,
**caractérisé en ce que** les dimensions latérales du nanofeuillet inorganique initial représentent au moins 3 fois l'épaisseur du nanofeuillet initial, et **en ce que** la température du milieu réactionnel est la température ambiante ou la température du milieu réactionnel est de 40°C à 80°C.

6. Un procédé selon la revendication 5 dans lequel on met en oeuvre les deux étapes précédentes (1) et (2) n fois où n est un entier supérieur ou égal à 1.

7. Un procédé selon l'une quelconque des revendications 5 ou 6 dans lequel on change l'élément R successivement à chacune des mises en oeuvre du procédé en fonction de la composition de la monocouche précédente, les monocouches étant de composition différente entre elles.

8. Systèmes luminescents, électroluminescents ou étages d'amplification d'un laser comprenant au moins une particule selon l'une quelconque des revendications **1** à **4.**

9. Catalyseurs comprenant au moins une particule selon l'une quelconque des revendications **1** à **4.**

10. Cellules photovoltaïques comprenant au moins une particule selon l'une quelconque des revendications **1** à **4.**

11. Transistors comprenant au moins une particule selon l'une quelconque des revendications **1** à **4.**

## Patentansprüche

1. Anorganisches kolloidales Partikel, das ein initiales anorganisches Nanosheet umfasst, das teilweise oder vollständig von mindestens zwei Monoschichten aus anorganischem Material bedeckt ist, wobei das initiale Nanosheet und die mindestens zwei Monoschichten aus mindestens zwei verschiedenen Materialien bestehen, wobei das Material, aus dem das initiale Nanosheet besteht, ausgewählt ist aus CdSe, CdS, CdTe, ZnS, ZnSe, ZnTe, HgS, HgSe oder HgTe, und wobei die mindestens zwei Monoschichten abgewechselt sind und aus Q und dann A oder umgekehrt bestehen, wobei:
Q Zn, Cd, Hg oder eine Mischung davon ist, und A S, Se, Te oder eine Mischung davon ist, oder
QA ZnO, CdO oder HgO ist, **dadurch gekennzeichnet, dass** die seitlichen Abmessungen des initialen Nanosheets mindestens das 3-fache der Dicke des initiales Nanosheets betragen.

2. Partikel nach Anspruch 1, mit einer Dicke von 0,5 nm bis 10 mm.

3. Partikel nach Anspruch 1 oder 2, dessen seitliche Abmessungen mindestens das 1,5-fache seiner Dicke betragen.

4. Partikel nach einem der Ansprüche 1 bis 3, wobei das kolloidale Partikel ausgewählt ist aus CdSe/CdS, CdS/ZnS, CdTe/CdSe, CdSe/ZnO, CdTe/Cd_{y}Zn_{1-y}SeₓS₁₋ₓ oder CdSe/Cd_{y}Zn_{1-y}S, wobei x und y Dezimalzahlen sind, die unabhängig voneinander von 0 bis 1 variieren.

5. Verfahren zum Dickenwachstum eines anorganischen kolloidalen Nanosheets durch Abscheidung von mindestens einem Element R auf mindestens einer Seite mindestens eines initialen anorganischen kolloidalen Nanosheets, was zu einem anorganischen kolloidalen Partikel führt, wobei das Verfahren die folgenden Schritte umfasst:
(1) mindestens ein anorganisches Nanosheet wird mit einem Präkursor des abzuscheidenden Elements R in Kontakt gebracht, wobei dieser Präkursor eine positive Oxidationsstufe aufweist, wenn das Nanosheet eine negative Oberflächenladung aufweist, und eine negative Oxidationsstufe aufweist, wenn das Nanosheet eine positive Oberflächenladung aufweist,
(2) eine Zeit t wird abgewartet, bis der Präkursor R mit den Atomen auf der Oberfläche des oder der Nanosheets reagiert hat, um eine Monoschicht von R zu bilden,
wobei der Präkursor des Elements R ein Präkursor von Q oder A ist,
wobei Q Zn, Cd, Hg oder eine Mischung davon ist und A S, Se, Te oder eine Mischung davon ist, oder
QA ZnO, CdO oder HgO ist,
wobei das Material, aus dem das initiale anorganische Nanosheet besteht, ausgewählt wird aus CdSe, CdS, CdTe, ZnS, ZnSe, ZnTe, HgS, HgSe oder HgTe,
wobei das anorganische Nanosheet vollständig oder teilweise von mindestens zwei Monoschichten bedeckt ist, und wobei die mindestens zwei Monoschichten abgewechselt sind und aus Q und dann A oder umgekehrt bestehen,
wobei das initiale anorganische Nanosheet und die mindestens zwei Monoschichten aus mindestens zwei verschiedenen Materialien bestehen,
**dadurch gekennzeichnet, dass** die seitlichen Abmessungen des initialen anorganischen Nanosheets mindestens das 3-fache der Dicke des initialen Nanosheets betragen und dass die Temperatur des Reaktionsmediums die Umgebungstemperatur ist oder die Temperatur des Reaktionsmediums 40 °C bis 80 °C beträgt.

6. Verfahren nach Anspruch 5, wobei die beiden vorhergehenden Schritte (1) und (2) n-mal ausgeführt werden, wobei n eine Ganzzahl größer oder gleich 1 ist.

7. Verfahren nach einem der Ansprüche 5 oder 6, wobei das Element R bei jeder Ausführung des Verfahrens nacheinander in Abhängigkeit von der Zusammensetzung der vorhergehenden Monoschicht geändert wird, wobei die Monoschichten untereinander eine unterschiedliche Zusammensetzung aufweisen.

8. Lumineszenz-, Elektrolumineszenz-Systeme oder Verstärkungsstufen eines Lasers, mindestens ein Partikel nach einem der Ansprüche 1 bis 4 umfassend.

9. Katalysatoren, mindestens ein Partikel nach einem der Ansprüche 1 bis 4 umfassend.

10. Photovoltaikzellen, mindestens ein Partikel nach einem der Ansprüche 1 bis 4 umfassend.

11. Transistoren, mindestens ein Partikel nach einem der Ansprüche 1 bis 4 umfassend.

## Claims

1. An inorganic colloidal particle comprising an initial inorganic nanosheet partially or totally covered by at least two monolayers of inorganic material, wherein the initial nanosheet and the at least two monolayers are made of at least two different materials, wherein the material making up the initial nanosheet is selected from CdSe, CdS, CdTe, ZnS, ZnSe, ZnTe, HgS, HgSe, or HgTe, and wherein the at least two monolayers are alternated and made of Q and then A or vice versa, wherein
Q is Zn, Cd, Hg, or a mixture thereof, and A is S, Se, Te or a mixture thereof, or
QA is ZnO, CdO or HgO,
**characterized in that** the lateral dimensions of the initial nanosheet represent at least 3 times the thickness of the initial nanosheet.

2. A particle according to claim **1,** having a thickness of 0.5 nm to 10 mm.

3. A particle according to claim **1** or **2,** the lateral dimensions of which represent at least 1.5 times its thickness.

4. A particle according to any one of claims **1** to **3,** wherein the colloidal particle is selected from CdSe/CdS, CdS/ZnS, CdTe/CdSe, CdSe/ZnO, CdTe/Cd_{y}Zn_{1-y}SeₓS₁ₓ, or CdSe/Cd_{y}Zn_{1-y}S, x and y being decimal numbers ranging from 0 to 1 independently.

5. A process for the thickness growth of an inorganic colloidal nanosheet by depositing at least one R element on at least one face of at least one initial inorganic colloidal nanosheet, resulting in an inorganic colloidal particle, the process comprising the following steps:
(1) at least one inorganic nanosheet is brought into contact with a precursor of the element R to be deposited, this precursor being of positive oxidation state if the nanosheet has a negative surface charge and a negative oxidation state if the nanosheet has a positive surface charge.
(2) waiting a time t that the R precursor has reacted with the atoms of the surface of the one or more nanosheets, to form a monolayer of R, wherein the precursor of the R element is a precursor of Q or A,
wherein Q is Zn, Cd, Hg, or a mixture thereof, and A is S, Se, Te, or a mixture thereof, or
QA is ZnO, CdO or HgO,
wherein the material making up the initial inorganic nanosheet is selected from CdSe, CdS, CdTe, ZnS, ZnSe, ZnTe, HgS, HgSe or HgTe,
in which the inorganic nanosheet is completely or partially covered by at least two monolayers and in which the at least two layers are alternated and made of Q then A or vice versa, in which the initial inorganic nanosheet and the at least two monolayers are composed of at least two different materials, **characterized in that** the lateral dimensions of the initial inorganic nanosheet represent at least 3 times the thickness of the initial nanosheet, and **in that** the temperature of the reactional environment is the ambient temperature or the temperature of the reactional environment is from 40°C to 80°C.

6. A process according to claim **5** in which the two preceding steps (1) and (2) are implemented n times where n is an integer greater than or equal to 1.

7. A process according to any one of claims **5** or **6,** in which the element R is changed successively at each of the implementations of the process as a function of the composition of the preceding monolayer, the monolayers being of different composition one to another.

8. Luminescent systems, electroluminescent systems or laser amplification stages comprising at least one particle according to any one of claims **1** to **4.**

9. Catalysts comprising at least one particle according to any one of claims **1** to **4.**

10. Photovoltaic cells comprising at least one particle according to any one of claims **1** to **4.**

11. Transistors comprising at least one particle according to any one of claims **1** to **4.**
